Europäisches Patentamt

(19)　European Patent Office

　　　Office européen des brevets

(11)　　**EP 0 825 491 A2**

(12)　　　　　　　　**EUROPEAN PATENT APPLICATION**

(43) Date of publication:
　　25.02.1998　Bulletin 1998/09

(51) Int. Cl.⁶: **G03F 7/20**

(21) Application number: 97114193.2

(22) Date of filing: 18.08.1997

(84) Designated Contracting States:
　　AT BE CH DE DK ES FI FR GB GR IE IT LI LU MC
　　NL PT SE

(30) Priority: 19.08.1996 JP 237273/96

(71) Applicant: Nikon Corporation
　　Tokyo 140 (JP)

(72) Inventors:
　• Takahashi, Tomowaki,
　　c/o Nikon Corporation
　　Chiyoda-ku, Tokyo (JP)
　• Ichihara, Yutaka,
　　c/o Nikon Corporation
　　Chiyoda-ku, Tokyo (JP)

(74) Representative:
　　Borchert, Uwe Rudolf, Dipl.-Ing. et al
　　Patentanwalt
　　Puschmann & Borchert
　　Patentanwälte
　　European Patent Attorneys
　　Postfach 10 12 31
　　80086 München (DE)

(54)　**Exposure apparatus of reduced projection scanning type**

(57)　　An exposure apparatus of a reduced projection scanning type can enlarge the exposure area while preventing enlargement of the exposure optical system. The apparatus includes a plurality of exposure optical systems having the same reduction scale ratio. Each optical system is formed such that the optical axis of the illuminating light and the optical axis of the exposure light are mutually parallel. The exposure area and the illumination area, as viewed from the direction of these optical axes, are mutually shifted so as to have an axis of similarity. The illumination areas of the optical systems are positioned on the same illumination plane. The exposure areas of the optical system are positioned on the same exposure plane. Axes of similarity of the optical systems mutually coincide. The object of illumination is positioned on the illumination plane and the object of exposure is positioned on the exposure plane. These objects are scanned in a mutually parallel manner with a speed ratio in accordance with the reduction scale ratio. The illumination and exposure areas of each optical system are provided so as to be continuous in a direction orthogonal to the direction of scanning the objects of illumination and exposure.

Fig. 2

## Description

BACKGROUND OF THE INVENTION

### 1. Field of the Invention

The present invention relates to a reduction exposure apparatus such as a stepper used in manufacturing semiconductors. More particularly, the invention relates to an exposure apparatus of a reduced projection scanning type which accomplishes projection exposure by using a reduction exposure optical system with an exposure magnification of 1/4x to 1/5x in the optical system.

### 2. Description of Related Art

Circuit patterns have become increasingly fine in the manufacturing of semiconductors and semiconductor chip mounting substrates. In exposure apparatuses which print these patterns, the need has arisen for devices with higher resolution. Furthermore, the exposure area of a single chip is also expanding.

In order to satisfy needs resulting from such developments, it is necessary to reduce the wavelength of a light source, increase the NA (numerical aperture) of the optical system and enlarge the field size. Technology is being developed which includes the use of a reduced projection optical system using a cata-dioptric system in order to shorten the wavelength of the light source.

In increasing the numerical aperture (NA) and enlarging the field size, enlarging of the optical system cannot be avoided. Hence, in place of the general exposure method used to date, a scanning-type exposure is being used in an attempt to avoid enlargement of the optical system while enlarging the field size. Further enlargement of a single chip is being sought, but enlargement of the exposure apparatus of a reduced projection scanning type, and, in particular, the exposure optical system, is an obstacle. Accordingly, a way of increasing the size of a single chip while avoiding enlargement of the optical system is becoming more necessary.

SUMMARY OF THE INVENTION

The present invention relates to this kind of an exposure apparatus, i.e. an exposure apparatus of a reduced projection scanning type. It is an objective of the present invention to provide an exposure apparatus of a reduced projection scanning type that can enlarge an exposure area and yet prevent enlargement of the exposure apparatus, particularly the exposure optical system.

The shape of the exposure area of the scanning-type exposure apparatus is a long, narrow rectangle or an arc. This long, narrow slit-shaped exposure area, however, is divided in two in its lengthwise direction. Separate optical systems are provided for each of the two divided exposure areas. Through this, two exposure apparatuses of only half the exposure length are prepared. While it might be thought that two half-length apparatuses are the same as before, relative to the size of the optical system, the exposure length, per apparatus, decreases by half. As a result, the volume is reduced to one-eighth, so that even when two apparatuses are used, the total volume can be reduced to one-fourth of an original volume.

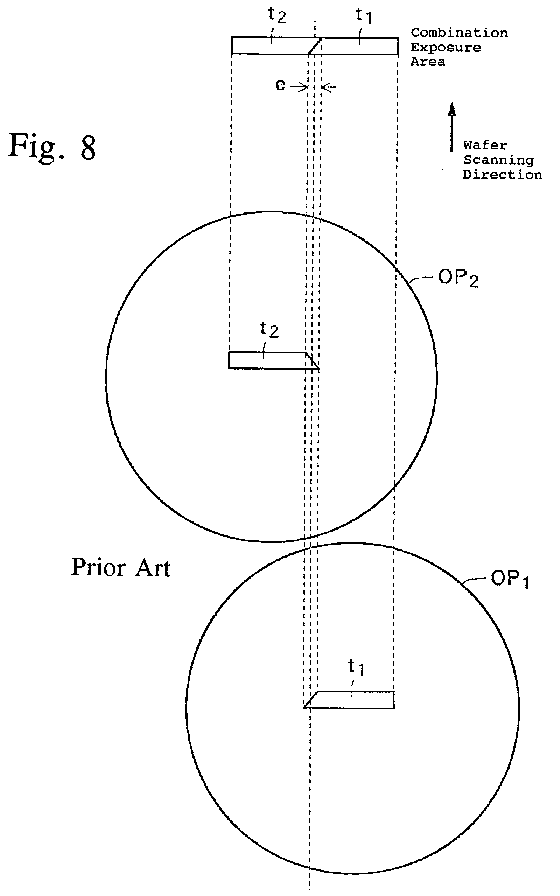

By joining the slit-shaped exposure areas in the lengthwise direction in this manner, it is possible to achieve enlargement of the exposure area. However, because the outer diameter of the individual optical systems is larger than the individual exposure areas, it is impossible to directly join the exposure areas in the lengthwise direction. Hence, the exposure area $t_1$ of a first optical system $OP_1$ and the exposure area $t_2$ of a second optical system $OP_2$ as shown in Fig. 8 are shifted in position by the amount necessary in the widthwise direction (scanning direction). These areas, in other words, are shifted by an amount corresponding to the outer diameter of the lens so that the two optical systems do not interfere. An overlap portion e is produced. If the object of exposure (e.g., a wafer) is scanned after this, then the exposure areas of the two optical systems that receive the results of scanning are joined even though the temporarily exposed areas $t_1$ and $t_2$ are separated in the two optical systems.

Thus, with a scanning-type exposure using a plurality of exposure areas $t_1$ and $t_2$, it is acceptable to join the individual slit-shaped exposure areas in the lengthwise direction (the direction orthogonal to the scanning direction). It is possible to position these areas so that they are separated from each other in the widthwise direction (scanning direction). Hence, it is possible to double the number of component exposure areas.

In normal optical systems, however, only optical systems with an exposure magnification of unity can be used. This is because in scanning-type exposure apparatuses, the object of illumination (e.g., a reticle) is scanned simultaneously with scanning of the object of exposure (e.g., a wafer). The scanning of the reticle is performed at the same time as the scanning of the wafer. The individual illumination areas need only be joined in the lengthwise direction and can be positioned so that they are separated from each other in the widthwise direction.

In the case of a reduction exposure with an exposure magnification of 1/2x or 1/4x, for example, in a normal optical system, when the exposure areas are joined one after another in the lengthwise direction, the illumination areas overlap in the lengthwise direction. In addition, when the illumination areas are joined one after another in the lengthwise direction, the exposure areas are separated from each other in the lengthwise direction.

As noted above, when the wavelength of light from the light source is shortened, it becomes necessary to compose the reduced projection optical system by using a cata-dioptric system. In this kind of cata-dioptric system, there is a spherical reflective mirror in the component elements of the optical system. Because the optical path is bent by this mirror, a composition with the optical axis of the illumination light and the optical axis of the exposure light out of place is often produced.

An optical system of this kind, with the optical axes of the illumination side and the exposure side being shifted, makes linking exposure possible by scanning while making the illumination side larger by the imaging magnification with respect to the scanning of the exposure side by positioning the optical system appropriately.

In order to arrange this kind of composition, the optical system must be one having a composition in which the optical axis is shifted in the middle. Fortunately, in a cata-dioptric system, the optical axis is shifted out of necessity and, consequently, this type of optical system is very well suited to the task of accomplishing a scanning-type exposure at a magnification other than unity.

The present invention was developed after consideration of the foregoing. According to the invention, an exposure apparatus of a reduced projection scanning type includes a plurality of exposure optical systems having the same reduction scale ratio. Each optical system is formed such that the optical axis of the illuminating light and the optical axis of the exposure light are mutually parallel. The exposure area and the illumination area, as viewed from the directions of these optical axes, are mutually shifted so as to have an axis of similarity. The illumination area of each optical system is positioned on the same illumination plane. The exposure area of each optical system is positioned on the same exposure plane, and the axes of similarity of the optical systems mutually coincide.

The object of illumination is positioned on the illumination plane and the object of exposure is positioned on the exposure plane. The object of illumination and the object of exposure are scanned in a mutually parallel manner with a speed ratio in accordance with the reduction scale ratio. The illumination area and exposure area of each optical system are provided so as to be continuous in a direction orthogonal to the direction of scanning the object of illumination and the object of exposure.

## BRIEF DESCRIPTION OF THE DRAWINGS

Fig. 1 is a schematic planar diagram showing an individual optical system used in the present invention.

Fig. 2 is a schematic planar diagram showing the principle behind the present invention.

Fig. 3 is a view showing the compositions of individual optical systems of a first embodiment.

Fig. 4 is a schematic planar view of the first embodiment.

Fig. 5 is a schematic frontal view of the first embodiment.

Fig. 6 is a schematic planar view of a second embodiment.

Fig. 7 is a schematic planar view of a third embodiment.

Fig. 8 is a schematic planar view of a conventional example.

## DESCRIPTION OF THE PREFERRED EMBODIMENTS

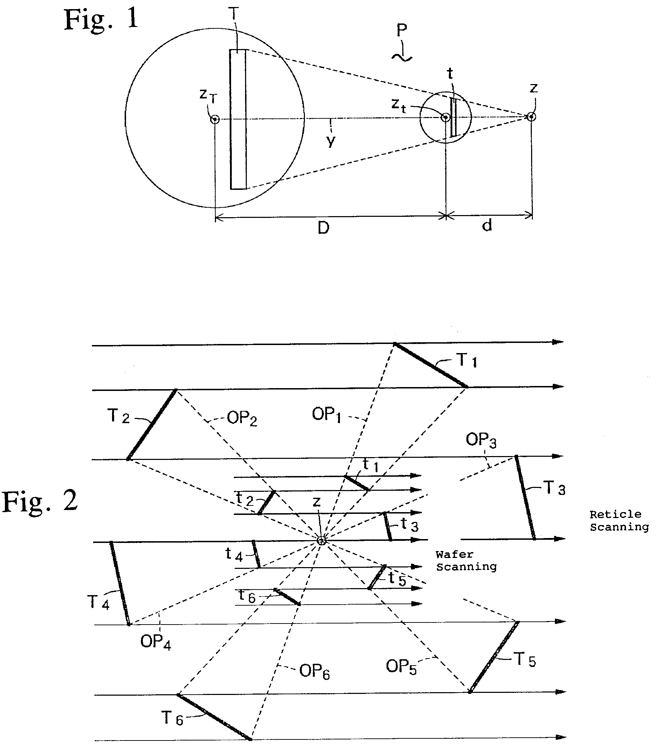

Each exposure optical system first accomplishes imaging with a reduction scale ratio $\beta$ ($0 < \beta < 1$). The optical axis $z_T$ of the illuminating light and the optical axis $z_t$ of the exposure light are formed parallel to each other as shown in Fig. 1. In addition, assuming the plane orthogonal to these optical axes $z_T$ and $z_t$ to be the projection plane P, the illumination area T and the exposure area t projected onto this projection plane P are formed so as to be mutually shifted. The term "shift" has a meaning not including rotation. Accordingly, after the illumination area T has been reduced by a reduction scale ratio $\beta$, it is possible to overlap the exposure area t by parallel movement in either direction on the projection plane P. As a result, the illumination area T and the exposure area t have an axis of similarity z, as shown in the drawing. Because the illumination area T and the exposure area t are shifted in the projection plane P, the two optical axes $z_T$ and $z_t$ are shifted by a distance D. A shift direction is designated y. When the distance from the optical axis $z_t$ of the exposure light to the axis of similarity z is called "d", the result is:

$$\beta = d / (d + D).$$

Accordingly,

$$d = \beta / (1 - \beta) \cdot D.$$

In order to cause the two optical axes $z_T$ and $z_t$ to shift, reflective surfaces exist in the optical system. Since the rotational direction of the image is reversed by one reflection, the total number of reflective surfaces is an even number.

Each of the exposure optical systems is composed as described above, but the illumination areas $T_1$ to $T_6$ and exposure areas $t_1$ to $t_6$ of each of the optical systems $OP_1$ to $OP_6$ are arranged so as to be respectively positioned on the same illumination planes and the same exposure planes, with the object being illuminated (e.g., a reticle) arranged on the illumination plane and the object being exposed (e.g., a wafer) arranged on the exposure plane. In addition, the axes of similarity z of the optical systems are arranged so as to mutually coincide, as shown in Fig. 2. Furthermore, the illumination

areas $T_1$ to $T_6$ and exposure areas $t_1$ to $t_6$ of each of the optical systems $OP_1$ to $OP_6$ are arranged so as to be continuous in a direction orthogonal to the scanning direction of the reticle and the wafer.

In the example shown in Fig. 2, six exposure optical systems $OP_1$ to $OP_6$ are used and the illumination areas $T_3$ and $T_4$ of the third optical system $OP_3$ and the fourth optical system $OP_4$ are arranged with mutually opposite orientations so as to abut the scanning line passing through the axis of similarity z. In addition, the illumination areas $T_2$ and $T_5$ of the second optical system $OP_2$ and the fifth optical system $OP_5$ are arranged so as to abut the scanning lines passing through the other end of the illumination areas $T_3$ and $T_4$ of the third optical system $OP_3$ and the fourth optical system $OP_4$ while not interfering with the other optical systems. Moreover, the illumination areas $T_1$ and $T_6$ of the first optical system $OP_1$ and the sixth optical system $OP_6$ are arranged so as to abut the scanning lines passing through the other end of the illumination areas $T_2$ and $T_5$ of the second optical system $OP_2$ and the fifth optical system $OP_5$ while not interfering with the other optical systems. As a result, the illumination areas $T_1$ to $T_6$ of the optical systems $OP_1$ to $OP_6$ are continuous in a direction orthogonal to the scanning direction of the object being illuminated. Each optical system has the axis of similarity z in common. Hence, if the illumination areas $T_1$ to $T_6$ are reduced with a ratio β centered about the axis of similarity z, then it is possible to overlap the exposure areas $t_1$ to $t_6$. That is to say, the exposure areas $t_1$ to $t_6$ also become continuous in a direction orthogonal to the scanning direction.

Following this, it is possible to accomplish exposure connected in a direction orthogonal to the scanning direction by scanning the reticle and the wafer in a mutually parallel manner at a speed ratio in accordance with the reduction scale ratio β.

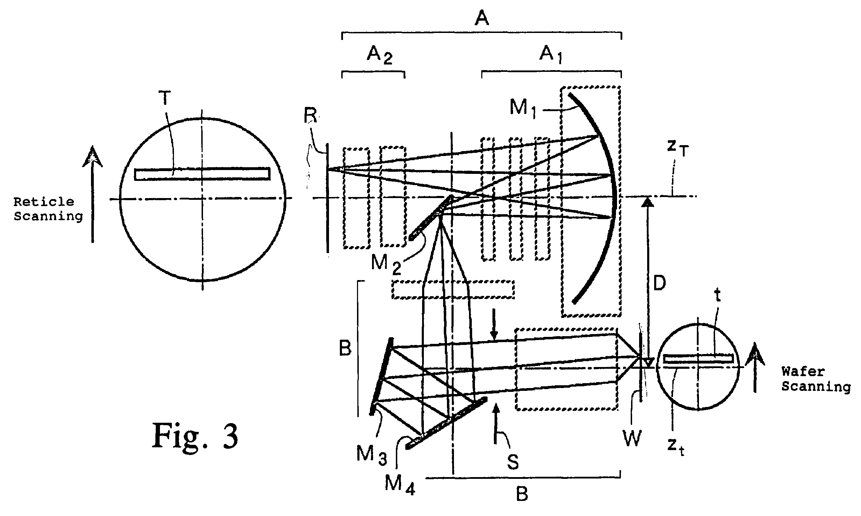

Fig. 3 shows a first embodiment of an individual exposure optical system. Each optical system has a first imaging optical system A that forms an intermediate image of a portion of the pattern drawn on a reticle R, a reflective surface $M_2$ arranged adjacent to the intermediate image, and a second imaging optical system B that forms an image of the intermediate image on a wafer W.

The first imaging optical system A is composed of a one-way optical system $A_1$ and a two-way optical system $A_2$, with a concave mirror $M_1$ arranged in the two-way optical system $A_2$. The reflective surface $M_2$ is arranged so as to guide the light passing on the return path through the two-way optical system $A_2$ toward the second imaging optical system B. An aperture diaphragm S, a reflective surface $M_3$ and a reflective surface $M_4$ are arranged in the second imaging optical system B. The concave mirror $M_1$ and the reflective surfaces $M_2$, $M_3$ and $M_4$ are arranged so that the optical axis $z_T$ of the illuminating light and the optical axis $z_t$ of the exposure light are mutually parallel and separated by a distance D from each other and, moreover, so that the illumination area T and the exposure area t, as viewed from the direction of these optical axes $z_T$ and $z_t$, are mutually shifted.

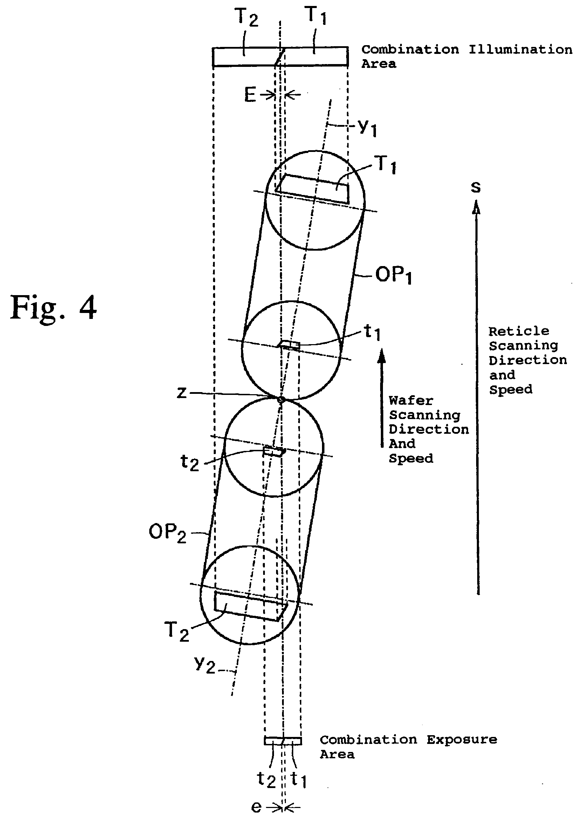

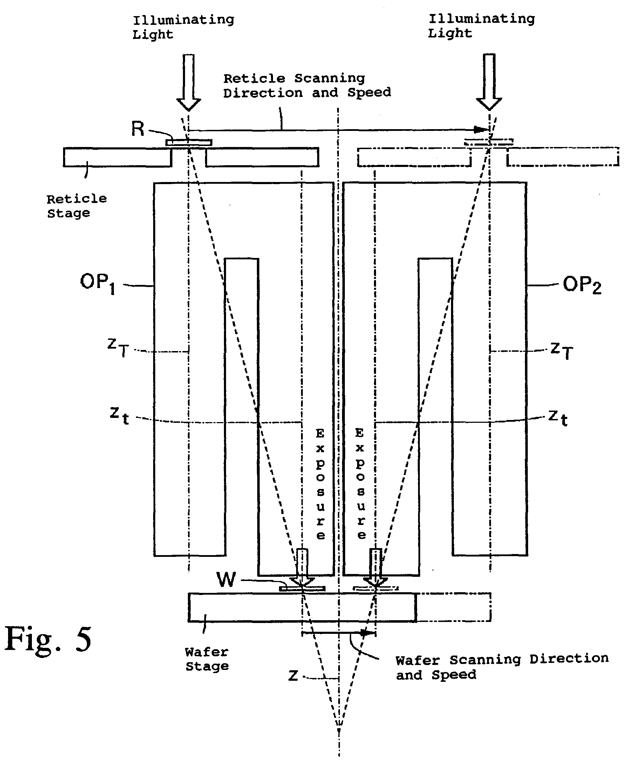

Fig. 4 shows the illumination area T and the exposure area t projected onto a projection plane orthogonal to the optical axis $z_T$ of the illuminating light and the optical axis $z_t$ of the exposure light, and Fig. 5 shows a schematic frontal drawing. As shown in these two figures, this first embodiment has two of the exposure optical systems shown in Fig. 1. The two optical systems $OP_1$ and $OP_2$ have the axis of similarity z in common. The illumination areas $T_1$ and $T_2$ of the two optical systems $OP_1$ and $OP_2$ are arranged with mutually opposite orientations so as to abut the scanning line passing through the axis of similarity z and, accordingly, the illumination areas $T_1$ and $T_2$ of the two optical systems are continuous in a direction orthogonal to the scanning direction. In addition, as a result of this, the exposure areas $t_1$ and $t_2$ are also continuous in a direction orthogonal to the scanning direction. Accordingly, it is possible to accomplish exposure, connected in a direction orthogonal to the scanning direction, by scanning the reticle R and the wafer W in a parallel manner at a speed ratio in accordance with the reduction scale ratio β.

Shift directions are designated $y_1$ and $y_2$.

So that the linking in the direction orthogonal to the scanning direction is accomplished smoothly, portions adjacent in the direction orthogonal to the scanning direction in the illumination areas $T_1$ and $T_2$ of the two optical systems become overlap portions E of mutual overlapping. Accordingly, in the exposure areas $t_1$ and $t_2$, portions adjacent in the direction orthogonal to the scanning direction also become overlap portions "e". The shape of the overlap portions E and e are formed so as to be decreased to a triangular shape so that the exposure amount of the overlap portion e is the same as the exposure amount of the non-overlapping portions.

By using this kind of composition for the two optical systems $OP_1$ and $OP_2$, it is possible to double the conventional exposure area with simplicity. In addition, if this invention is applied to a conventional exposure area, then the exposure area need only be one-half in one of the optical systems and, consequently, the size (length) of the optical system need only be half the size otherwise necessary. Because the volume of the lens and lens barrel that compose the optical system is proportional to the third power of length, the volume is in fact reduced to one-eighth that of the original volume.

When the constituent elements are made more compact in this manner, it is possible to reduce costs in nearly all fields including material expenses, processing expenses, assembly expenses, adjustment expenses, and so forth.

However, in this case, the width of the exposure slit is also reduced by one-half. Consequently, the width of the exposure slit must be enlarged two-fold in order to realize the same throughput, and hence some enlargement is necessary. However, this enlargement of the width does not cause the same degree of enlargement of the optical system as enlargement in the lengthwise direction does.

In any event, with the present invention, it is possible to enlarge the exposure area and also to make the optical system more compact if necessary.

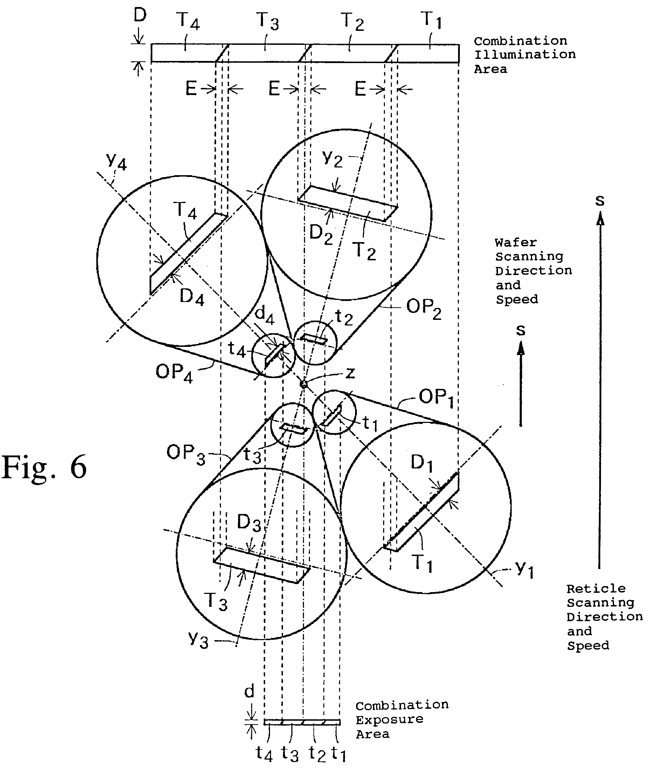

Fig. 6 shows a second embodiment in which each of the optical systems $OP_1$ to $OP_4$ is composed the same as in the first embodiment. This second embodiment, however, uses four optical systems. Accordingly, it is possible to obtain a greater impact from the efficacy of the above-described first embodiment. Because the exposure amounts by the individual optical systems $OP_1$ to $OP_4$ must naturally be the same, the width D of the illumination area $T_1$-$T_4$ measured along the scanning direction is the same for each of the optical systems $OP_1$ to $OP_4$. In addition, the width d of the exposure area $t_1$-$t_2$ measured along the scanning direction is the same for each of the optical systems $OP_1$ to $OP_4$.

As a result, in the second optical system $OP_2$ and the third optical system $OP_3$ arranged close to the scanning line passing through the axis of similarity z, the lengthwise direction of the illumination areas $T_2$ and $T_3$ thereof and the exposure areas $t_2$ and $t_3$ thereof are nearly orthogonal to the scanning line passing through the axis of similarity z, and hence the widths $D_2$, $D_3$, $d_2$ and $d_3$ of the illumination areas $T_2$ and $T_3$ and the exposure areas $t_2$ and $t_3$ orthogonal to the lengthwise direction are widened as shown in Fig. 6. On the other hand, in the first optical system $OP_1$ and the fourth optical system $OP_4$ arranged separated from the scanning line passing through the axis of similarity z, the lengthwise direction of the illumination areas $T_1$ and $T_4$ thereof and the exposure areas $t_1$ and $t_4$ thereof are far from orthogonal to the scanning line passing through the axis of similarity z, and hence the widths $D_1$, $D_4$, $d_1$ and $d_4$ of the illumination areas $T_1$ and $T_4$ and the exposure areas $t_1$ and $t_4$ orthogonal to the lengthwise direction are narrowed as shown.

In both of the embodiments described above, the optical axis $z_T$ of the illuminating light and the optical axis $z_t$ of the exposure light are shifted in a direction orthogonal to the lengthwise direction of the illumination area T and the exposure area t. It is not necessarily required, however, for the lengthwise direction of the illumination area T and the exposure area t to be orthogonal to the direction y of the shift of the two optical axes $z_T$ and $z_t$.

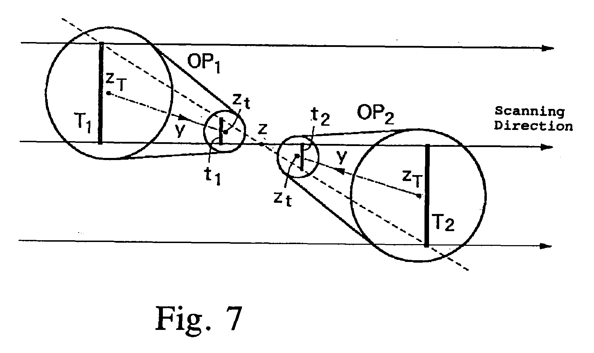

That is to say, in the first embodiment, it is possible to provide the lengthwise direction of the illumination area T and the exposure area t orthogonal to the scanning direction s, rotated somewhat in the counterclockwise direction in Fig. 4, as shown in Fig. 7. At this time, the lengthwise direction of the illumination area T and the exposure area t is not orthogonal to the direction of shifting of the two optical axes $z_T$ and $z_t$. This, however, is achieved through, for example, addition of a new reflective surface and adjustment of the reflective surfaces $M_2$, $M_3$ and $M_4$. That is to say, depending on the situation, it is possible to make the optical system shown in Fig. 3 an optical system in which the optical axis $z_t$ of the exposure light is eccentric in a direction not orthogonal to the lengthwise direction of the illumination area T and the exposure area t.

In addition, in both of the above-described embodiments, the shift amount D of the optical axes $z_T$ and $z_t$ of the illuminating light and the exposure light is the same for each of the optical systems. However, it is enough for each of the optical systems to have the same reduction scale ratio $\beta$ and to have the axis of similarity z in common. The shift amount D of the two optical axis $z_T$ and $z_t$ may differ for each optical system. The number of optical systems may also be an odd rather than an even number.

The present invention provides an exposure apparatus which uses a plurality of small optical systems having the exact same reduction scale ratio and which can make the exposure surface area several times larger at once. The effects of this are significant.

In reduced exposures of magnifications other than the normal unity magnification, an appropriate way of producing a partitioned exposure previously could not be found or was extremely troublesome. In the present invention, however, a superior partitioned exposure that can be adapted even to a reduced exposure is provided. Furthermore, compactness of the optical system can be realized and there are many beneficial points concerning production costs. If the optical systems used have the same composition, the benefit of increased mass production cannot be overlooked.

The particular embodiments described above are only examples and are not to be considered the only embodiments encompassed by the following claims.

## Claims

1. An exposure apparatus of a reduced projection scanning type comprising:

    a plurality of exposure optical systems having the same reduction scale ratio;
    each optical system being formed such that an optical axis of illuminating light and an optical axis of exposure light are mutually parallel;
    an exposure area and an illumination area of each optical system, as viewed from a direction of the optical axes, being mutually shifted so as to have an axis of similarity;
    each illumination area of each optical system being positioned on a common illumination plane;
    each exposure area of each optical system being positioned on a common exposure plane;

said axes of similarity mutually coinciding with axes of similarity of remaining optical systems of the plurality of exposure optical systems;

an object of illumination being positioned on said illumination plane and an object of exposure being positioned on said exposure plane, the object of illumination and the object of exposure being scanned in a mutually parallel manner with a speed ratio corresponding to said reduction scale ratio;

said illumination area and said exposure area of each optical system being provided so as to be continuous in a direction orthogonal to a direction of scanning the object of illumination and the object of exposure.

2. The exposure apparatus as defined in claim 1, wherein a shift direction of the optical axis of the illuminating light and the optical axis of the exposure light of each optical system is a direction orthogonal to a lengthwise direction of said illumination area and said exposure area.

3. The exposure apparatus as defined in claim 1, wherein a shift amount of the optical axis of the illuminating light and the optical axis of the exposure light is made the same for each optical system.

4. The exposure apparatus as defined in claim 1, wherein, in the illumination area and exposure area of each optical system, adjacent portions in a direction orthogonal to said direction of scanning the object of illumination and the object of exposure are formed so as to mutually overlap.

5. The exposure apparatus as defined in claim 1, wherein widths of said illumination area and exposure area as measured along the direction of scanning the object of illumination and the object of exposure are formed mutually equivalent for each optical system, respectively.

6. The exposure apparatus as defined in claim 2, wherein a shift amount of the optical axis of the illuminating light and the optical axis of the exposure light is made the same for each optical system.

7. The exposure apparatus as defined in claim 2, wherein, in the illumination area and exposure area of each optical system, adjacent portions in a direction orthogonal to said direction of scanning the object of illumination and the object of exposure are formed so as to mutually overlap.

8. The exposure apparatus as defined in claim 3, wherein, in the illumination area and exposure area of each optical system, adjacent portions in a direction orthogonal to said direction of scanning the object of illumination and the object of exposure are formed so as to mutually overlap.

9. The exposure apparatus as defined in claim 6, wherein, in the illumination area and exposure area of each optical system, adjacent portions in a direction orthogonal to said direction of scanning the object of illumination and the object of exposure are formed so as to mutually overlap.

10. The exposure apparatus as defined in claim 2, wherein widths of said illumination area and exposure area as measured along the direction of scanning the object of illumination and the object of exposure are formed mutually equivalent for each optical system, respectively.

11. The exposure apparatus as defined in claim 3, wherein widths of said illumination area and exposure area as measured along the direction of scanning the object of illumination and the object of exposure are formed mutually equivalent for each optical system, respectively.

12. The exposure apparatus as defined in claim 4, wherein widths of said illumination area and exposure area as measured along the direction of scanning the object of illumination and the object of exposure are formed mutually equivalent for each optical system, respectively.

13. The exposure apparatus as defined in claim 6, wherein widths of said illumination area and exposure area as measured along the direction of scanning the object of illumination and the object of exposure are formed mutually equivalent for each optical system, respectively.

14. The exposure apparatus as defined in claim 7, wherein widths of said illumination area and exposure area as measured along the direction of scanning the object of illumination and the object of exposure are formed mutually equivalent for each optical system, respectively.

15. The exposure apparatus as defined in claim 8, wherein widths of said illumination area and exposure area as measured along the direction of scanning the object of illumination and the object of exposure are formed mutually equivalent for each optical system, respectively.

16. The exposure apparatus as defined in claim 9, wherein widths of said illumination area and exposure area as measured along the direction of scanning the object of illumination and the object of exposure are formed mutually equivalent for each optical system, respectively.

17. The exposure apparatus as defined in claim 1, wherein each of said exposure optical systems includes a plurality of reflective surfaces.

18. The exposure apparatus as defined in claim 17, wherein each of said exposure optical systems includes a concave mirror and at least one reflective surface for guiding the illuminating light therethrough.

19. The exposure apparatus as defined in claim 18, wherein each of the optical systems further includes a pair of reflective surfaces for transmitting exposure light received from said one reflective surface toward said exposure area.

20. The exposure apparatus as defined in claim 1, wherein said plurality of exposure optical systems includes four optical systems.

# Fig. 1

# Fig. 2

Reticle
Scanning

Wafer
Scanning

Fig. 3

# Fig. 4

Combination Illumination Area

$T_2$  $T_1$

$E$

$y_1$

$T_1$

$S$

$OP_1$

$t_1$

Reticle Scanning Direction and Speed

$z$

Wafer Scanning Direction And Speed

$t_2$

$OP_2$

$T_2$

$y_2$

Combination Exposure Area

$t_2$  $t_1$

$e$

Fig. 5

Fig. 6

Fig. 7

Fig. 8

Prior Art